# EUROPEAN PATENT APPLICATION

(11) **EP 4 553 595 A1**
(43) Date of publication of application: **14.05.2025**
(21) Application number: 23209498.7
(22) Date of filing: 13.11.2023
(51) Int. Cl.: G05B 19/409, G05B 19/418, H02K 41/02, G06F 30/20

(54) **CONFIGURATION METHOD AND TOOL FOR CONFIGURING A LINEAR MOTOR APPLICATION**

(71) Applicant: ABB Schweiz AG, 5400 Baden (CH)
(72) Inventor: Koppelmans, Hayo, 5582JC Waalre (NL); Stacey, Derrick, Atlanta GA 30307 (US); Staudecker, Martin, 4040 Lichtenberg (AT); Griessler, Leopold, 4020 Linz (AT)
(74) Representative: Patentanwälte Pinter & Weiss OG

(57) **Abstract**

In order to simplify configuring new linear motor applications it is provided that stator segments (Sm) are arranged in a layout view (12) of a planning view (11) to form a workspace (WS) of the linear motor (1) and displaying the workspace (WS) in the layout view (12), that workstations (Wj) ar earranged in the workspace (WS) and simultaneously displaying the workstations (Wj) in a workflow view (13) of the planning view (11), that the workstations (WS) are connected in the layout view (Wj) and/or in the workflow view (13) according to a given workflow (WF) that defines an order of sequence of workstations (Wj), whereas the workflow (WF) is displayed in the workflow view (13) in the form of a flowchart with the workstations (Wj) as nodes that are linked by connections that define the order of sequence, and that the layout view (12) and the workflow view (13) are dynamically linked such that a change in the configuration of the linear motor (1) in the layout view (12) is automatically reflected in the flowchart of the workflow view (13), and/or vice versa.

## Description

The present invention pertains to a configuration method and configuration tool for configuring a linear motor application.

Linear motors can be distinguished between long-stator linear motors and planar motors. In both cases a shuttle of the linear motor is provided that is moved as a result of an interaction of magnetic fields produced by the shuttle and the stator of the linear motor. The main difference is that in a long-stator linear motor, the stator extends only in direction of movement, whereas in a planar motor, the stator extends two-dimensionally and provides a movement plane in which a shuttle can be moved freely in two directions.

In a long-stator linear motor, a plurality of magnetic elements are arranged next to one another in a stationary manner along a stator. The magnetic elements can be electrical drive coils. The drive coils are controlled by a control unit to generate a time-variable and moving magnetic field in the desired direction of movement by energizing the respective drive coils of the stator in the region of a shuttle. Alternatively, magnetic elements can be permanent magnets, which are moveably arranged on the stator to generate the time-variable and moving magnetic field. A number of drive magnets, either as permanent magnets or as an electrical coil or a short-circuit winding, which are separated by an air gap from the magnetic elements of the stator and which interact with the magnetic elements, are arranged on a shuttle.

By generating a time-varying and moving magnetic field with the magnetic elements, e.g. by energizing the drive coils, in the region of the drive magnets of the shuttle, a magnetic field can be generated which interacts with the magnetic field of the drive magnets in order to generate a propulsive force and/or a normal force (in the direction transverse to the movement direction) acting on the shuttle. The shuttle is moved by the propulsive force. As a result, the shuttle can be moved in the desired manner along the track. It is also possible, and usually the case, to have several shuttles that are moved simultaneously and independent from each other along the track.

Usually, the stator comprises a plurality of stator segment, with each stator segment having a specific number of magnetic elements. The stator segments can also have different geometries, such as straight lines, curves, switches etc. The stator segments can then be assembled to form the desired stator by arranging them in a row. A stator therefore builds a track for the shuttle, the shuttle follows during movement. It is also possible to have several tracks in a long-stator linear motor that are connected by switches. A shuttle may then change tracks at a switch.

Examples of long-stator linear motors can be found in WO 2013/143783 A1, US 6,876,107 B2, US 2013/0074724 A1 or WO 2004/103792 A1.

A planar motor substantially has a stator which forms a movement plane. One or more stator segments usually build the stator of the planar motor. A stator segment is usually in the shape of square or rectangle. Stator segments can be connected to form virtually any pattern to form the movement plane - from squares, rectangles to complex shapes that traverse around other equipment or to link different working stations of a production process. One or more movable devices, so-called shuttles, can be moved mainly in two dimensions in the movement plane formed by the stator. For this purpose, magnetic elements are usually arranged on the stator, in particular on the stator segments of the planar motor. The magnetic elements can be electrical drive coils. The drive coils are controlled by a control unit to generate a time-variable and moving magnetic field in the desired direction of movement by energizing the respective drive coils of the stator in the region of a shuttle. Alternatively, magnetic elements can be permanent magnets, which are moveably arranged on the stator to generate the time-variable and moving magnetic field. The shuttle comprises a magnet unit which includes drive magnets (permanent magnets or electromagnets). The drive magnets are arranged two-dimensionally distributed on the shuttle. The magnet unit of the shuttle or rather the drive magnets of the magnet unit interact electromagnetically with the moving magnetic field of the stator so that a drive force and a levitation force can be exerted on the shuttle. Furthermore, it is also conceivable that only fixed permanent magnets are mounted on the stator as magnetic elements and the moving magnetic field is generated on the shuttle. In connection with the present disclosure, the stationary unit of the planar motor is generally referred to as stator, which comprises at least one stator segment and the devices, which are moveable in the movement plane defined by the stator are referred to as shuttles, regardless of the mode of operation.

The drive force generated by the electromagnetic interaction between shuttle and stator can be used to move the shuttle in the desired direction of movement of the movement plane. The levitation force can be used to lift off the shuttle from the stator surface to an operation height (e.g., a few millimeters to a few centimeters) and to maintain the shuttle at that operation height during operation (e.g., as long as the drive coils are energized or the permanent magnets of the stator are moving). Thus, for example, an air gap is created and/or configured by the levitation force. The air gap between the shuttle and the stator surface can be maintained and the shuttle can magnetically levitate at operation height above the stator surface during the operation of the linear motor. Additionally, tilting forces and moments acting on the shuttle can also be generated for more complex movements. A two-dimensional interaction of the magnetic fields of the stator and of the shuttles is required to enable the two-dimensional movement of the shuttles, which is characteristic for a linear motor. The magnetic elements of the stator and the drive magnets are therefore advantageously arranged in such a way that, in addition to a one-dimensional movement along the axes spanned by the movement plane (e.g., x- and y-axis based on a coordinate system defined by the movement plane), more complex two-dimensional movements of the shuttle in the transport plane are also possible.

Planar motors are well known in prior art. US 9,202,719 B2, for example, discloses the basic structure and the mode of operation of a planar motor.

Modern linear motors make it also possible to carry out high-precision movements of the shuttle. In the example of a long-stator linear motors, the high-precision movement is mainly in direction of movement along the stator, whereas also limited movements across the direction of movement is also possible. In the example of planar motors, the shuttles are levitating above the stator surface and can be moved in the direction of all six rigid body degrees of freedom. Translational movements of the shuttle in two main directions of movement (e.g., x-and y-direction based on the coordinate system fixedly defined by the movement plane) are possible with virtually no restrictions, due to the modular design of the stator - comprising one or more stator segments. In addition, a translation of the shuttle in a third spatial direction ("lifting" or "lowering" of the shuttle in z-direction based on the coordinate system fixedly defined by the movement plane) and rotations of the shuttle (up to a specific deflection) can be carried out at least to a limited extent. The motor forces and torques required for these shuttle movements are generated by means of (electro) magnetism.

The invention pertains to planar motors, as well as to long-stator linear motors. In the following only the term "linear motor" is used that encompass both, i.e. planar motors and long-stator linear motor.

A linear motor can be used as a transport device in a production process, for example, wherein very flexible transport processes with complex motion profiles can be implemented. A motion profile can be given as position of a shuttle over time, or speed of a shuttle over time, or speed of a shuttle in dependence of position, etc. Such applications of a linear motor as a transport device are well known in the prior art.

For implementing a transport task with a linear motor, not only the stator, i.e. the arrangement of the stator segments, and the positions of workstations, for processing objects transported with shuttles of the linear motor, on or along the stator need to be planned, but also the movement paths of the shuttles. For a planar motor, the movement path are on the movement plane of the stator, whereas in a long-stator linear motor, the movement path is along the stator, whereas several stators can be connected tby switches. The movement path is the route the shuttle takes when the linear motor is operated, e.g. a route on the movement plane. EP 4 194 375 A1, WO 2020/109276 A1 and US 10,926,418 B2 are examples of how shuttle movement paths are planned for a planar motor, especially in order to avoid collisions of shuttles when the motions are performed.

Linear motor technology is inherently flexible in the way it can be configured in respect to arrangement of the stator segments and the positions of workstations on the stator, as well as in respect to the definition of movement paths of the shuttles on the stator. Last but not least, the shuttles can also be moved with different dynamics (speed, acceleration, jerk, etc.). Usually, with a linear motor not only a simple motion task is performed, i.e. moving a shuttle from A to B. The linear motor is usually integrated in a workflow, e.g. a sequence of manufacturing process steps on transported objects that need to be carried out at workstations in predefined order, with the linear motor performing the transporting of the object from one workstation to the next in the predefined order. The workflow can in general be regarded as the sequence of workstations required for implementing a desired task with the linear motor. Because of its flexibility, the linear motor is perfectly suited for different tasks. But this flexibility entails also a great complexity in designing and planning new linear motor applications. For designing and planning linear motor configuration tools are required that allow a user to configure a linear motor to the needs of its application.

However, today there is only the most basic graphical system configuration tools in the market for linear motor technology. For a planar motor, this is mostly a grid-based deployment of segments in an array of X by Y segments, then a user deselects any segments within this given grid size that are not actually present in the specific application. Workflows and other parameters are handled through programmatic steps and static table entries which lack any dynamic capabilities. Such an approach is quite burdensome for the user and requires also programming knowledge of the user.

Hence, there is a need to provide a method and a tool for configuring new linear motor applications which allows to utilize the inherent flexibility of linear motors without profound programming knowledge of a user.

This is achieved in that stator segments are arranged in a layout view of a planning view to form a workspace of the linear motor and displaying the workspace in the layout view. Furthermore, workstations are arranged in the workspace and are simultaneously displayed in a workflow view of the planning view, preferably next to the layout view. These steps can be done by a user in an easy way and especially graphically in the layout view or workflow view. The workstations are connected in the layout view and/or in the flowchart view according to a given workflow that defines an order of sequence of workstations, whereas the workflow is displayed in the flowchart view in the form of a flowchart with the workstations as nodes that are linked by connections that define the order of sequence. This connecting step can also easily be done by a user graphically. To support the user in the configuration, the layout view and the flowchart view are dynamically linked such that any change in the configuration of the linear motor in the layout view is automatically reflected in the flowchart of the flowchart view, and/or vice versa. This allows the user to edit a configuration of a linear motor either in the workflow view or in the layout view, whichever is more suitable. With this configuration method, a linear motor application can be configured graphically and without programming knowledge. A linear motor application can thus be planned intuitively and in an easy way.

Arranging of stator segments or group of stator segments and of workstations is preferably done by drag and drop. To this end also snap-on of segments or group of stator segment to a given grid or other segments can be implemented. Arranging the stator segments or group of stator segments or workstations is done by the user software based graphically. This supports the user in configuring the workspace and allows quick configuration of the workspace.

Also connecting the workstations is preferably done by the user fully graphically (software based), by drawing a line between two workstations in the layout view or in the workflow view. This supports the user in configuring the workflow and allows quick configuration of the linear motor.

Adding or removing a workstation or a connection in one of the views is advantageously reflected in the respective other view. This also support the user in configuring the linear motor significantly. The user can freely choose in which of the view he wants to work as every change is immediately displayed in both views.

It is especially advantageous when configuration method further comprises the step of automatically planning movement paths between the workstations in the workspace according to the order of sequence defined by the connections of the workstations and according to given planning rules. With the movement paths, the configuration can be used for operating the linear motor. The configuration can be used by the control unit of a linear motor to control movement of the shuttles along the movement paths. To this end, the configuration method can also automatically generate software instructions for moving the shuttles along the movement paths from workstation to workstation in the order of sequence of the flowchart for realizing the workflow.

The configuration can further be supported when the configuration method further comprises the step of simulating the movement of the shuttles along the movement paths for realizing the workflow for a given time period and in accordance with given dynamic parameters of the movements of the shuttles. By use of the simulation, the user gets immediate feedback if the configuration works when the linear motor is operated.

It is especially advantageous, when a characteristic parameter of the operation of the linear motor is determined during the simulation. Such characteristic parameter can be used to compare different configurations for the same workflow in order to optimize the configuration terms of a certain goal that is measured with the characteristic parameter.

The present invention is described below in greater detail with reference to Figs. 1a through 4, which show schematic and non-limiting advantageous embodiments of the invention by way of example. In the drawings:
Figs.1a and Fig. 1b are different views of a possible embodiment of a planar motor,
Fig.2 is an exemplary embodiment of a workspace of a planar motor,
Fig.3 shows an inventive planning view,
Fig.4 shows the planning of movement paths of shuttles and
Fig.5 shows a configuration computer system for the configuration tool and method.

The invention is described in the following using the example of a planar motor as an embodiment of a linear motor but can also be applied analogously to other embodiments of a linear motor, especially such as a long-stator linear motor.

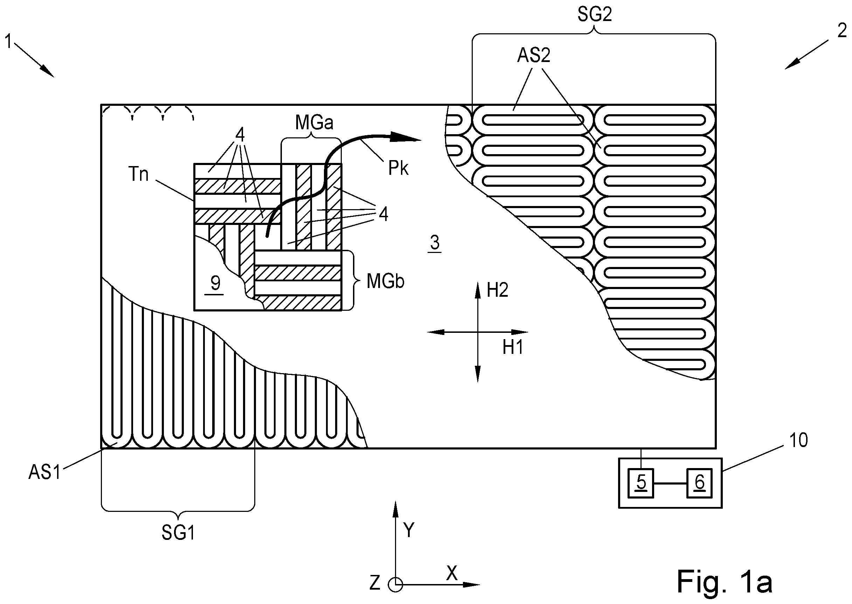

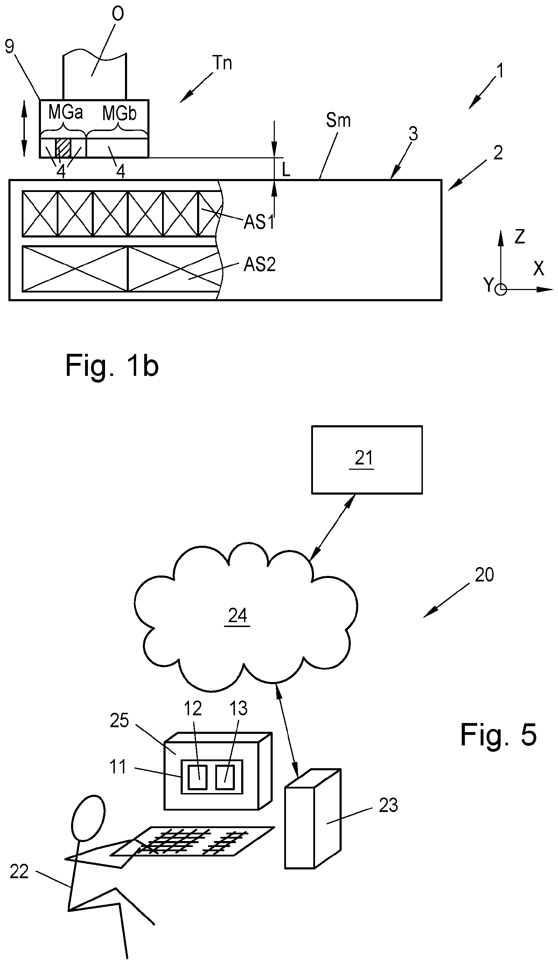

With reference to Figs. 1a and Fig.1b the well-known principle of a planar motor as example of a linear motor 1 is explained by way of an exemplary embodiment. Figs.1a and 1b show a simplified exemplary embodiment of a transport device in the form of a planar motor. Fig.1a shows the planar motor in a partially broken-away plan view, and Fig.1b shows the planar motor in a partially broken-away side view. The planar motor has at least one stator segment Sm. "m" is used as an index in order to be able to distinguish different stator segments, wherein, generally, the reference sign Sm is used when no specific stator segment is addressed. The stator segment(s) Sm form the stator 2 with a movement plane 3. At least one shuttle Tn is movable in the movement plane 3 at least two-dimensionally in two main movement directions H1, H2, that correspond to x and y axis of a coordinate system. "n" is used as an index in order to be able to distinguish different shuttles, wherein, generally, the reference sign Tn is used when no specific shuttle is addressed. Within the scope of the invention, the movement plane 3 refers to the planar surface of the stator 2 and stator segment Sm, which movement plane 3 is determined by the size and shape of the stator 2. The movement plane 3 can be oriented in space in any way. For the sake of simplicity, only one stator segment Sm is shown in Fig.1a. Of course, a plurality of stator segments Sm (which can be different in shape) is usually arranged next to each other in order to form the stator 2 and a larger movement plane 3. As a result, the planar motor can have a modular workspace WS defined by the arrangement of stator segments Sm, and movement planes 3 of different shapes and sizes can be realized. In the movement plane 3 of the stator 2, several shuttles Tn can naturally also be moved simultaneously and independently of one another. It is even possible to use shuttles Tn of different size or shape, for transporting different objects O, for example.

It is to note, that the useable workspace WS does not necessarily correspond to the complete movement plane 3 formed by the stator segments Sm. It is possible that the shuttles Tn are blocked from entering certain defined blocked regions BR of the movement plane 3.

A first coil group SG1 with several drive coils AS1, which defines the first main movement direction H1, and a second coil group SG2 with several drive coils AS2, which defines the second main movement direction H2, are arranged on the stator segment Sm. In general, the drive coils are also designated by ASi, where "i" is an index, in order to be able to distinguish the drive coils if necessary. The drive coils AS1 of the first coil group SG1 are arranged next to each other in a specific direction - in this case, in the X-direction of a Cartesian coordinate system - in order to form the first main movement direction H1 for the movement of the shuttle Tn, which in this case extends along the X-axis. The drive coils AS2 of the second coil group SG2 are arranged next to each other in a specific direction - in this case, the Y-direction of a Cartesian coordinate system - in order to form a second main movement direction H2 for the shuttle Tn, which in this case extends along the Y-axis. The drive coils AS1, AS2 of the first and second coil groups SG1, SG2, as shown in Fig. a, are preferably arranged relative to one another such that the two main movement directions H1, H2 are orthogonal to one another.

Several drive magnets 4 are arranged on the at least one shuttle Tn, which interact electromagnetically with drive coils AS1, AS2 of at least one of the two coil groups SG1, SG2 in the region of the shuttle Tn for moving the shuttle Tn. For this purpose, the shuttle Tn generally has a main body 9, on the underside of which (facing the movement plane 3) the drive magnets 4 are arranged, as can be seen in Fig. 1b. In Fig. 1a, the main body 9 is shown largely broken away to be able to see the arrangement of the drive magnets 4. As indicated in Fig.1b, the drive magnets 4 are arranged in several magnet groups MGa, MGb. The drive magnets 4 are usually arranged with alternating polarity, as indicated in Fig.1b. The drive magnets 4 can also be oriented differently in the different magnet groups MGa, MGb.

In the example shown, two first magnet groups MGa and two second magnet groups MGb are arranged on the shuttle Tn. A single first magnet group MGa and a single second magnet group MGb per shuttle Tn are substantially sufficient to move the shuttle Tn in the movement plane 3. Of course, more than two first magnet groups MGa and more than two second magnet groups MGb can also be arranged per shuttle Tn. There are many different arrangements of magnet groups MGa, MGb known, like a 1-D arrangement, 2-D arrangement, a Halbach arrangement etc.

With a planar motor as shown in Fig.1a and Fig.1b, a substantially unrestricted movement of a shuttle Tn in the two main movement directions H1, H2 would be possible, for example, in the movement plane 3 of the stator segment 2. It could in this case be possible to move the shuttle Tn, for example, only along the X-axis or only along the Y-axis. The shuttle Tn can naturally be moved simultaneously in both main movement directions H1, H2, e.g., along a two-dimensional movement path Pk lying in the movement plane 3 with an X-coordinate and a Y-coordinate, as indicated on the shuttle Tn in Fig.1a. "k" is used as an index in order to be able to distinguish different movement paths, wherein, generally, the reference sign Pk is used when no specific movement path is addressed. But also the other four degrees of freedom can also be used at least to a limited extent (translational movement in the vertical direction Z and rotation about the three axes X, Y, Z).

A movement path Pk can be an open path, i.e., a path whose beginning and end do not coincide, or a closed path, i.e., a path whose beginning and end coincide.

Drive coils ASi can also be arranged one above the other in the normal direction (here, in the Z-direction). In the embodiment according to Fig.1b, the drive coils AS1 of the first coil group SG1 are arranged closer to the movement plane 3 in the direction perpendicular to the movement plane 3 (here, in the Z-direction) than the drive coils AS2 of the second coil group SG2. There are many different arrangements of drive coils ASi known, like a single-layer arrangements, a herringbone arrangement, a double-layer arrangement etc.

A control unit 10 is also provided in the planar motor, with which the drive coils ASi of the stator segment 2 are controlled for energizing, as indicated in Fig.1a, in order to generate the magnetic fields for moving shuttles Tn. Essentially, this means that the drive coils ASi are energized by the control unit 10 such that the shuttle Tn executes a desired movement path Pk in the movement plane 3 and with a desired motion profile, wherein the movement path Pk is not limited only to a movement in the main movement directions H1, H2, but can also specify movements in the four other degrees of freedom. The movement path Pk is to be defined, e.g., for implementing a transport task with the planar motor as a transport device or in dependence of a specific production process of a system in which the planar motor is integrated as a transport device. The planar motor, and more specifically the drive coils ASi of the planar motor, is controlled by the control unit 10 such that a shuttle Tn moves along the desired movement path Pk in the movement plane 3. The control unit 10 controls not only the movement path Pk but also the dynamics of the movement, especially speed, acceleration, jerk, at any point in time.

An actual value of the movement of the shuttle Tn, e.g., an actual position (also an actual orientation of the shuttle Tn) or an actual speed, is usually also used for the implementation or control of the movement path Pk in the control unit 10. For this purpose, suitable sensors, e.g., position sensors, can also be arranged on the stator segment 2, the detected measured variables of which are transmitted as actual values of the movement to the control unit 10 or from which actual values of the movement are determined in the control unit 10.

The control unit 10 can also be designed as a distributed controller, e.g., having a number of coil control units 5, for example one coil control unit 5 per stator segment Sm, and a superordinate system control unit 6 that is connected to the number of the coil control units 5 - for example, via a communications network. For example, the system control unit 6 can implement the transport task and prespecify target points for the shuttle Tn in the movement plane 3 to the segment control unit in order to move the shuttle Tn according to a movement path Pk to perform the transport task. For this purpose, power electronics can also be provided on a stator segment Sm, which power electronics generate the required coil voltages or coil currents and apply them to the drive coils ASi.

A control unit can be implemented as microprocessor-based hardware, e.g., as a computer, microcontroller, digital signal processor (DSP), programmable logic controller (PLC), etc., on which corresponding control programs for implementing the respective function run. An embodiment as an integrated circuit, such as, for example, an application-specific integrated circuit (ASCI) or field programmable gate array (FPGA), is also conceivable.

In operation of the planar motor, in a possible embodiment, a moving magnetic field is generated in the first main movement direction H1 by corresponding activation of the first drive coils AS1. The moving magnetic field in the first main movement direction H1 mainly interacts electromagnetically with the drive magnets 4 of the first magnet group(s) MGa in order to move the respective shuttle Tn in the first main movement direction H1. Analogously, by activating the second drive coils AS2, a substantially moving magnetic field is generated in the second main movement direction H2, which substantially moving magnetic field mainly interacts electromagnetically with the drive magnets 4 of the second magnet group(s) MGb in order to move the shuttle Tn in the second main movement direction H2. Depending upon the activation of the drive coils AS1, AS2, the moving magnetic fields are superimposed, as a result of which the shuttle Tn can be moved in the desired manner along the prespecified two-dimensional movement path Pk in the movement plane 3. As already mentioned also movements in further degrees of freedom could be realized as well.

The drive coils ASi are usually activated in such a way that a force acts on the shuttle Tn in the direction of the Z-axis, with which force the shuttle Tn is kept levitating above the movement plane 3 for generating an air gap L (Fig.1b) (which is also possible while the shuttle Tn is at a standstill).

A long-stator linear motor, as further example of a linear motor 1, differs from a planar motor mainly in that the drive coils ASi are arranged next to each other along the stator so that the movement plane is reduced to a movement line that is defined by the geometric shape of the stator. It Is not necessary to have drive coils ASi for different directions in a long-stator linear motor. Also on a shuttle Tn of long-stator linear motor, there are usually not drive magnets for different directions of movement. The workspace WS of a long-stator linear motor is also defined by its stator, whereas stators can also be connected by switches.

The above explanation regarding the structure and function of a linear motor 1 are merely for explanatory purposes and are not to be understood as limiting, and serve for better understanding the invention. For the present invention, it is irrelevant how the linear motor 1 is constructed in detail.

In order to operate a linear motor 1, the linear motor 1 and the movement of the shuttles Tn need to be planned and configured first in order to realize a desired workflow WF. The workflow WF is the sequence of workstations Wj required for implementing the desired task with the linear motor 1. j" is used as an index in order to be able to distinguish different workstations, wherein, generally, the reference sign Wj is used when no specific workstation is addressed. The workflow WF may also contain additional information like process time at workstations Wj, dynamic parameters for the movement of shuttles Tn between workstations Wj or other relevant operational data. Such parameters could be defined for each workstation Wj, as well as for the travel between each workstation Wj along a movement path Pk.

The configuration of the linear motor 1 includes the arrangement of the stator segments Sm and the arrangement of a number j workstations Wj in the region of the stator 2 the shuttles Tn, that transport a certain object O, travel to. The number of shuttles Tn may vary and the configuration comprises at least one shuttle Tn, usually a plurality of shuttles Tn. It is also possible to use different shuttles, e.g. different in size or dynamic capabilities, in a linear motor 1 configuration. For realizing the workflow WF, the object O can be transported with the same shuttle Tn through all required workstations Wj or with different shuttles Tn. The shuttles Tn must travel to the workstations Wj in a certain order in order to perform certain tasks on the transported objects O for realizing a workflow WF.

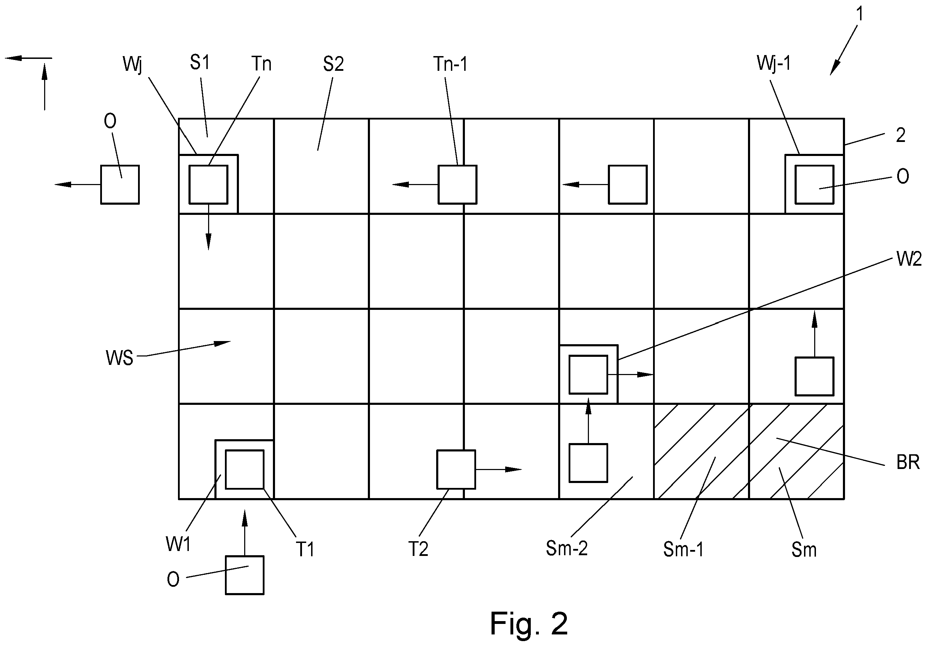

Fig.2 shows a simple configuration of a planar motor having a plurality of stator segments Sm that define a rectangular shaped stator 2. In the shown configuration, the stator segments Sm, Sm-1 represent a blocked region BR (indicated hatched) of the stator 2 and must not be entered by the shuttles Tn, at least during normal operation of the planar motor. The workspace WS of the planar motor, i.e. the area in which shuttles Tn may move, is therefore defined by the stator segments S1 to Sm-2. There are four workstations W1 to Wj arranged on the stator 2 and the shuttles Tn travel to all workstations Wj in a predefined order. The arrows at the shuttles Tn indicate the direction of movement of the respective shuttle Tn. In this example, in the first workstation W1, an object O is placed on the shuttle TE1. The shuttles Tn then travels to the next workstations W2, Wj-1, avoiding the blocked region BR (indicated hatched) of the stator 2. In these workstations W2, Wj-1 certain tasks are performed on or with the object O. The shuttles Tn travel next to the last workstation Wj at which the finished processed object O is removed from the shuttle Tn.

There are many different applications possible for linear motors 1, like life sciences, assembly, pharma, intralogistics, laboratory automation, packaging, food, beverage, E-mobility, battery manufacturing, etc., but the invention is not limited to a specific application. The application just influences the workflow WF and the workstations Wj required to implement the workflow WF.

In a simple example, the planar motor of Fig.2 is used in a laboratory to transport blood samples (object O) to different blood analysis stations (workstations W2, Wj-1). The blood samples are loaded on a shuttle T1 in a loading station (workstation W1) and are then moved to the blood analysis stations in a certain order. After analysis, the blood samples are removed from the shuttle in an unloading station (workstation Wj) and the empty shuttles Tn are returned to the loading station or a shuttle buffer. In order to increase throughput, there could be several blood analysis stations in parallel that perform the same analysis and a shuttle Tn with a blood sample travels to a free workstation.

The invention pertains to a configuration tool and method that allow the user to configure a linear motor 1 for performing a desired workflow WF in a simple, intuitive and easy way. The such configured linear motor 1 is then used to carry out the workflow WF by moving the shuttles Tn along defined movement paths Pk and with the desired dynamics to the required workstations Wj in the defined order. To this end the layout of the linear motor 1, especially of the stator 2, needs to be configured, in order to define the workspace WS for the linear motor 1 application. Furthermore, the workstations Wj required for the workflow WF need to be positioned on or in the region of the workspace WS of the stator 2. Different applications or workflows WF require different linear motor 1 layouts, in size as well as in shape. Then the movement paths Pk of the shuttles Tn for moving the shuttles Tn from one workstation Wj to the next in the required order of sequence need to be planned and defined. With the movement paths Pk, the control unit 10 can control the movement of the shuttles Tn for performing the workflow WF with the linear motor 1.

It is however rather difficult to plan a workflow WF directly on the layout of a workspace WS of the stator 2 especially when the workflow WF is complex with several workstations Wj, possibly also with parallel paths with equal workstations Wj, as the workflow WF is not immediately reflected in the planned layout of the stator 2 and the positions of the workstations Wj. The workflow WF would be more intuitive in form of a flowchart as sequence of workstations Wj that are connected in a certain way. On the other hand, in a flowchart no information is comprised how a workspace WS of a linear motor 1 has to look like in order to implement the workflow WF.

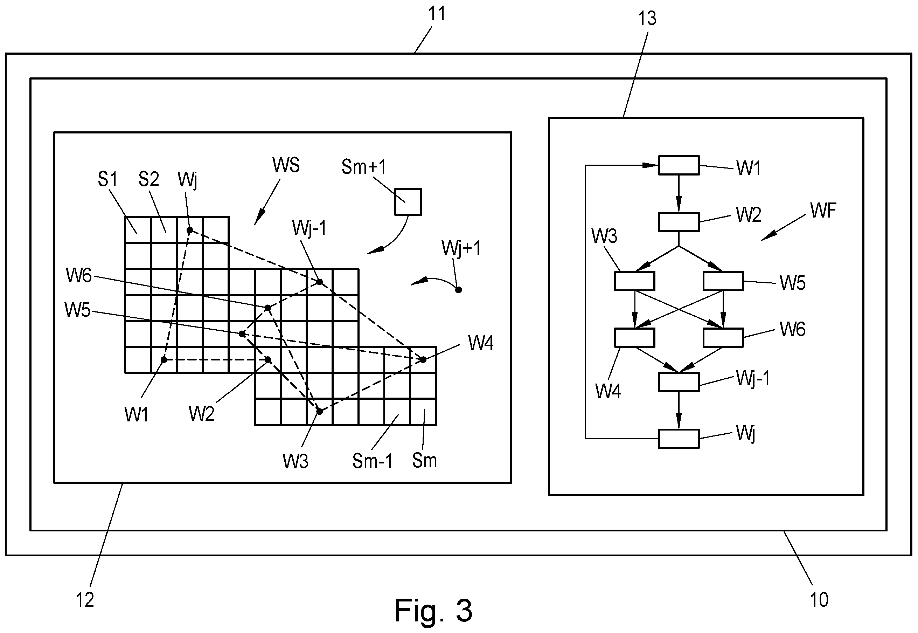

The basic approach of the invention is to use both, namely the layout of the workspace WS and the workflow WF, simultaneously for configuring the linear motor 1. With this approach, the advantages of both can be utilized and their inherent drawbacks can be avoided. The inventive configuration tool and method use a planning view 10 that is shown on a display 11 to the user. The display 11 can be a computer screen, for example. The planning view 10 comprises a layout view 12 and a workflow view 13 that are shown simultaneously to the user, preferably next to each other. This is schematically shown in Fig.3.

The planning view 11 is displayed on a computer screen, for example, of a configuration computer system 20 on which configuration software is installed. When the configuration software is run on the configuration computer system 20, the configuration method can be carried out. It is also possible that the configuration software runs on a server computer 21 and the user 22 accesses the configuration software from another computer 23 (client) connected to the server computer 21, over the internet 24, for example. The configuration software could be accessible via a web browser on the computer 23 of the user 22. The client computer 23 of the user 22 comprises a display 25, at which the planning view 11 is displayed. The user 22 may control the configuration software by means of ordinary computer input / output devices, like a computer mouse, a touchscreen, a keyboard, etc. Such an embodiment of the configuration computer system 20 of the configuration tool is shown in Fig.5.

In the layout view 12 the workspace WS of the linear motor 1 is graphically shown with its stator segments Sn, and possibly also with any blocked regions BR.

As already mentioned, in case of a long-stator linear motor as linear motor 1, also switches could be provided to connect stators. Such switches are considered as special stator segments Sm and can be handled in the configuration tool and method like stator segments Sm.

The configuration tool and method allow the user to freely arrange (graphical representations of) stator segments Sm in any desired number and configuration for defining the workspace WS of the linear motor 1. The user may also define a certain region of the workspace WS, that does not necessarily correspond to whole stator segments Sm, as blocked region BR.

To this end, it is advantageous that the stator segments Sm can be arranged by the user by "drag and drop" to build the desired workspace WS. The drag and drop is a software feature that allows the user to do this graphically in the layout view 12, by means of a computer mouse or on a touchscreen, for example. The user selects a stator segment Sm, from a menu or selection list of a software interface, for example, and drags it into the layout view 12. This is indicated in Fig.3 with the stator segment Sm+1 that is dragged by the user to the workspace WS. It is also advantageous in this connection that the stator segments Sm are arranged in the layout view 12 with the use of snap-on connections, i.e. the placed stator segments Sm are automatically placed in the correct way when a stator segment Sm is dropped by the user close to an already present stator segment Sm in the workspace WS. It is also possible that the segment is snapped onto a defined grid of the workspace WS. It is also possible that not only single stator segments Sm can be arranged by the user, but also predefined stator segment groups comprising a number of stator segments Sm in a predefined arrangement. For example, a segment group in a L- shape comprising four stator segments Sm or in a rectangular or square shape comprising any number of stator segments Sm could be defined. The user could then drag and drop such segment groups.

The configuration tool and method allow also to place (graphical representations of) workstations Wj in the workspace WS of the linear motor 1, also preferably by drag and drop and with snap-on to correct, defined positions on a stator segment Sm. This is indicated in Fig.3 with the workstation Wj+1 that is dragged by the user to the workspace WS. Also a workstation Wj could be selected by the user from a menu or a list of available workstations Wj.

A blocked region BR could be defined by the user in the layout view 12 by drawing a region with defined shape in the workspace WS or by selecting certain stator segments Sm.

The layout of the workspace WS can also be altered or edited at any time during the configuration, also preferably by drag and drop. This could be done by adding stator segments Sm and/or workstations Wj to the workspace WS or removing certain stator segments Sm and/or workstations Wj from the workspace WS or by rearranging or repositioning certain stator segments Sm and/or workstations Wj. Such editing can easily be carried out software-based in graphical way in the layout view 12.

It is also possible that planning of the linear motor 1 starts with a predefined workspace WS having a predefined shape and number or stator segments Sm and that this predefined workspace WS is adapted by the user by adding or removing or rearranging stator segments Sm.

It is recognizable in Fig.3 that it is hardly possible to identify a workflow WF only by means of the workstations Wj in the workspace WS and only from the layout view 12.

Therefore, the workflow view 13 is shown in parallel in the planning view 10. The workflow view 13 displays a workflow WF as a sequence of workstations Wj that are required for implementing a required task with the linear motor 1 in a flowchart. The necessary and available workstations Wj for realizing a certain task are of course known.

In the workflow WF the sequence of workstations Wj is shown by way of a flowchart. In the flowchart, a node represents a workstation Wj and the sequence is given by the arrows connecting the nodes. The arrow starting from a workstation Wj-1 indicates the next workstation Wj that has to follow for implementing the desired workflow WF.

In the example of Fig.3, the flowchart comprises also parallel branches with equal workstations W3, W4 and W5, W6 in each branch. For realizing the desired task, a shuttle Tn has to follow one of the parallel branches. It would be almost impossible to recognize such parallel branches in the layout view 12, for example.

The workflow view 13 and the layout view 12 are interconnected and dynamically linked by the configuration tool and method, i.e. by software. This means, on the one hand, that each workstation Wj exists in the layout view 12 and in the workflow view 13. The order of sequence of the workstations Wj is shown in the workflow view 13 by way of the arrows that link the nodes (workstations Wj) in the flowchart. The connection of workstations Wj is preferably also be shown in the layout view 12, as indicated in Fig.3 with the dashed lines connecting workstations Wj. But in the layout view 12, the connections do not necessarily reflect an order of sequence.

The interconnected and dynamically linked workflow view 13 and layout view 12 allow the user to configure a linear motor 1 application in the layout view 12 by arranging (placing / adding / removing / rearranging) stator segments Sm and/or workstations Wj. The workstations Wj can be connected in the layout view 12, the connection indicating which workstation Wj can be reached from which other workstation Wj. This is dynamically reflected in the workflow view 13 by way of a flowchart. The flowchart, however, does not only reflect the connections of the workstations Wj (as in the layout view), but does also give in the flowchart the order of sequence of the workstations WF. The user can follow and check the configuration in the layout view 12 in parallel in the resulting flowchart of the workflow WF. The user could however also configure the linear motor 1 application in the workflow view 13 and by means of a flowchart of the workflow WF. The user could define a workflow WF in the workflow view 13, by connecting workstations Wj to a flowchart, and the workstations Wj in the workflow WF could be dynamically added to the existing workspace WS in the layout view 12. The workstations Wj could be positioned on available segments Sm in the workspace WS. The user could then place or reposition the workstations Wj in the workspace WS in the layout view 12 as need be. In praxis, the configuration will likely be a mixture of both, with the user working in the layout view 12 and in the workflow view 13 with the changes in one view being dynamically reflected in the other view.

It is possible that editing the workspace WS, the arrangement of stator segments Sm, the arrangement of workstations Wj is only allowed in the layout view 12 and that changes in the layout view 12 are reflected into the workflow view 13. It is however also possible that editing is only possible in the flowchart of the workflow view 13 and that changes in the workflow view 13 are reflected into the layout view 12. But it is highly beneficial to be able to work seamlessly between the workspace WS in the layout view 12 and the flowchart in the workflow view 13. Therefore, it is highly advantageous that editing is allowed in both, the layout view 12 and the workflow view 13, and that a change in one of the views is dynamically linked into the respective other view.

Dynamically linking therefore means, on the other hand, that the layout view 12 and the workflow view 13 are linked such that a change in the configuration of the linear motor 1 in the layout view 12 is automatically reflected in the flowchart of the workflow view 13, and/or vice versa. "and/or vice versa" means, that a change in the configuration of the linear motor 1 in the layout view 12 is automatically reflected in the flowchart of the workflow view 13, or that a change in in the flowchart of the workflow view 13 is automatically reflected in the configuration of the linear motor 1 in the layout view 12, or that a change in the configuration of the linear motor 1 in the layout view 12 is automatically reflected in the flowchart of the workflow view 13 and a change in in the flowchart of the workflow view 13 is automatically reflected in the configuration of the linear motor 1 in the layout view 12.

Connecting of workstations Wj in the layout view 12 or in the flowchart of the workflow view 13 could be done graphically (i.e. software-based), by drawing a line between two workstations Wj, for example. To this end, the graphical objects representing the workstations Wj in the layout view 12 or in the workflow view 13 could have connection points at which an end of a drawn line automatically connects to, preferably also by snap-on. Connecting two workstations Wj could however also be realized by graphically selecting two points (e.g. connection points), which are then command based automatically connected by a line.

Once the desired workflow WF has been planned and configured by the user, the configuration tool and method can automatically plan the movement paths Pk in the workspace WS the shuttles Tn have to follow in order to travel through the workstations Wj of the workflow WF in the given order of sequence. The configuration tool and method comprise a movement path planning tool that is implemented as software that is run on the configuration computer system 20. For a long-stator linear motor as linear motor 1, planning of a movement paths Pk can involve setting of switches, if a shuttle Tn has to change tracks for realizing a movement path Pk.

The planning of the movement paths Pk by the movement path planning tool can be performed according to predefined rules. For example, it could be provided that a movement path Pk connects two workstations Wj with the shortest path possible in the workspace WS. It could also be provided that the path may only be aligned parallel to the edges of the stator segments Sm. The shuttles Tn would then only travel in one of the main movement directions H1, H2 at one time.

It is possible to use a well-known modified A* (A-star) pathfinding algorithm using customized weighting to plan and optimize the movement paths Pk to offer the optimal layout for a high volume of shuttles Tn in the smallest possible workspace WS. The A* algorithm tries to find an optimal path in some environment, which in the present application is a grid of segments. The goal is to get from a start position (workstation Wj-1, for example) to a target position (workstation Wj, for example) in the best possible way. This is not always the shortest path as other requirements to be satisfied could be defined. For example, two shuttles Tn can move in opposite directions, and it must be ensured that they do not collide by making enough space between these two opposite paths. Furthermore, it could be desirable to avoid making turn moves, as the shuttles Tn would have to brake and hold still for a certain time (dwell time) before moving on. This would reduce the final throughput. The weightings of the algorithm can be configured for optimizations based on user preferences, like shortest travel distance or minimal direction changes.

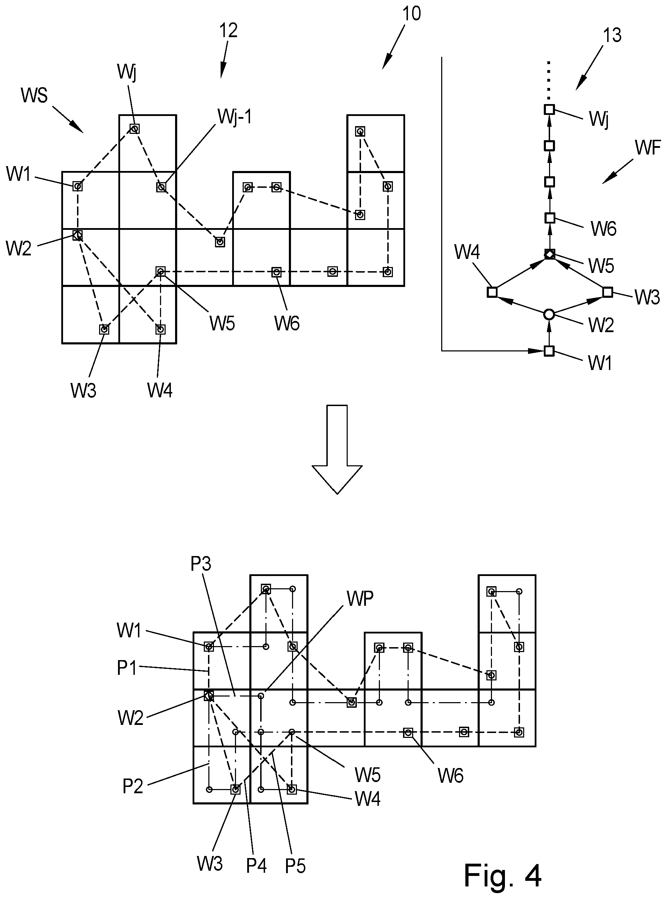

Fig.4 shows a workspace WS of a planar motor in the layout view 12 resulting from such a planning.

In Fig.4 the planned workspace WS in the layout view 12 and the planned workflow WF in the workflow view 13 are shown. The automatic path planning leads to the movement path BP1 connecting the first workstation W1 with the second workstation W2, to the movement path BP2 connecting the second workstation W2 with the third workstation W3, to the movement path BP3 connecting the second workstation W2 with the fourth workstation W4 (parallel to the third workstation W3), to the movement path BP4 connecting the third workstation W3 with the fifth workstation W5, to the movement path BP5 connecting the third workstation W3 with the fifth workstation W5, and so on.

It could be provided in the configuration tool and method, that a planned movement path Pk is graphically (i.e. software based) changed or adapted by the user in the layout view 12, preferably by dragging a path at defined points of the path.

In a further aspect of the invention the configuration tool and method allow adding a waypoint WP in the workspace WS. A waypoint WP is a point a movement path Pk has to go through and can therefore be used to influence the route of a movement path Pk. The planning of the movement paths Pk would consider defined waypoints WP. A movement path Pk is planned that a set waypoint WP, assigned to the movement path Pk, lies on the planned movement path Pk. Waypoints WP could also be editable in the workspace WS by the user, preferably graphically (i.e. software based) by drag and drop in the layout view 12. Fig.4 shows a waypoint WP on the path P3 between workstation W2 and W4, for example.

A waypoint WP can also be used in order to define entry or exit points of workstations Wj. Such waypoints WP can be part of a workstation Wj and would then be automatically set in the workspace WS when the workstation Wj is included in the workspace WS.

It is also conceivable that the automatic planning of the movement paths Pk is not possible with the given planning rules and with the given workspace WS. For example, if two workstations Wj can only be connected by a movement path Pk in a way that another movement path Pk is crossed, then such a configuration could be forbidden, because crossing movement paths Pk could lead to collisions of moving shuttles Tn. There can also other rules be implemented in the configuration tool and method for checking if a possible movement path Pk is allowed or not.

In case a movement path Pk between two workstations Wj cannot be planned with the existing planning rules, the planning can stop and the configuration tool and method can indicate to the user where a problem with the movement paths Pk exists, preferably directly in the layout view 12 and/or the workflow view 13. This can be done graphically (i.e. software based) in the respective view, for example. The user can then edit the workspace WS by adding or removing or rearranging at least one stator segment Sm or by repositioning a workstation Wj, for example.

The configuration tool and method can also propose to the user how the workspace WS needs to be adapted to allow a movement path Pk. The configuration tool and method could for example place a new segment Sm in the layout view 12 at a required position or could reposition a workstation Wj. The user can then accept the proposed adaptation or manually adapt the workspace WS.

Another possible outcome of the planning of the movement paths Pk is that stator segments Sm that are not used in implementing the workflow WF can be identified. If a stator segment Sm is not used at all, this could be indicated to the user by the configuration tool and method, preferably graphically (i.e. software based) in the layout view 12, and such a stator segment Sm could be removed from the workspace WS.

For moving a shuttle Tn along the planned movement paths Pk, software instructions can automatically be generated by a software generation tool of the configuration tool and method with which the linear motor 1 is controlled for moving the shuttle Tn from one workstation Wj to a next workstation Wj in the order of sequence of the flowchart for realizing the workflow WF. The software instructions can be in the form of simple movement instructions, like instructions to move from a current coordinate on the workspace WS to a destination coordinate (defining the location of a workstation, for example) on the workspace WS. For that a coordinate system could be defined in the workspace WS. With such instructions a motion profile for moving a shuttle Tn with certain dynamic parameters can be created by the configuration tool and method or the control unit 10 of the linear motor 1. It is however also possible that the configuration tool and method or the control unit 10 of the linear motor 1 creates a motion profile for moving a shuttle Tn with certain dynamic parameters on basis of the planed movement paths Pk. The motion profile realizes the movement of the shuttle Tn. A motion profile could be in the form of a speed ramp over time with which the shuttle Tn is first accelerated with a given acceleration until a given speed in a required direction is achieved, then the shuttle Tn is moved with this speed before the shuttle Tn is decelerated with a given deceleration so that the destination coordinate is reached. To this end a motion planning tool can be included in the configuration tool and method or can be run as software on the control unit 10 that controls movement of a shuttle Tn according to provided movement instructions.

The motion planning tool can also comprise a routine for deciding which branch a shuttle Tn has to follow in case of parallel branches of the workflow. Such a decision can be made on basis of the current workload of the workstations in the parallel branches, for example.

For that it is necessary that the default or maximum dynamic parameters, like speed, acceleration, jerk, dwell time before change of direction etc., of the movement of the shuttles Tn are known to the motion planning tool. For example, a default speed of 2m/s, acceleration of 20m/s² and a dwell time of 1s could be set. These dynamic parameters could also be set differently for different shuttles Tn. This can be ensured by setting the required dynamic parameters in the motion planning tool. It is also possible that the required dynamic parameters are stored in a parameter set of a shuttle Tn being used in the linear motor 1 application. The motion planning tool could then receive the dynamic parameters from the parameter set of a shuttle Tn. This means that these dynamic parameters could be predefined.

The configuration tool and method allow to configure a linear motor 1 without the need to write a single line of code, which considerably simplifies and speeds up the configuration of the linear motor 1.

With the planned movement paths Pk it is also possible that the configuration tool and method simulates the workflow WF by simulating the movements of the shuttles Tn in the workspace WS along the planned movement paths Pk. To this end, the configuration tool and method could include a simulation tool. The simulation tool is basically software that is run on the configuration computer system 20. For simulation it is necessary that the dynamic parameters, like speed, acceleration, jerk, dwell time before change of direction etc., of the movement of the shuttles Tn are known to the simulation tool. This can be ensured by setting the required dynamic parameters in the simulation tool. It is also possible that the required dynamic parameters are stored in a parameter set of a shuttle Tn being used in the linear motor 1 application. This means that these parameters could be predefined.

The simulation of the workflow WF for a given time period, a couple of minutes, hours, days, etc., can be used to evaluate the configuration of the linear motor 1. For evaluating the configuration characteristic parameters could be calculated or determined during simulation. Examples of characteristic parameters are overall throughput of shuttles Tn, individual workstation Wj throughput and workstation Wj utilization. The higher the value of these parameters, the better a configuration is. The user can therefore make different linear motor configurations, like different workspaces WS, for a certain workflow WF in order to compare and improve a certain characteristic parameter. The throughput could be defined as number of shuttles Tn per time unit (e.g. minute) at a certain point in the workspace WS (that can be set by the user) or in a workstation Wj. Also a usage rate (percentage) of a workstation Wj could be used as characteristic parameter, i.e. for evaluating parallel branches of the workflow WF.

In practice it could be helpful to graphically animate the simulation of movements of the shuttles Tn for performing the workflow WF and to show the animation to the user. To this end, the configuration tool and method can also comprise an animation tool. The animation tool is basically software that is run on the configuration computer system 20. The animation tool animates the movement of the shuttles Tn along the movement paths Pk in the layout view 12 in order to give the user graphical feedback on how the operation of the linear motor 1 could look like. The animation could also be performed with slowed down or sped up time. Also for the animation, the dynamic parameters, like speed, acceleration, jerk, dwell time before change of direction etc., of the movement of the shuttles Tn are known to the simulation tool. This can be ensured by setting the required dynamic parameters in the animation tool. It is also possible that the required dynamic parameters are stored in a parameter set of a shuttle Tn being used in the linear motor 1 application. This means that these parameters could be predefined. The user could use the animation to make edits in the workspace WS or position of workstations Wj or waypoints WP.

In the simulation and/or in the animation, also other operational parameters, like a processing time in a workstation Wj, could be considered. Such additional operational parameters could be provided to the respective tool in the same way as the dynamic parameters. Such parameters could also be part of a parameter set of the workstations Wj and could be obtained from such parameter sets.

In the simulation and/or animation, also random events could be considered. Random events could be any random disturbances, like malfunctions of shuttles or workstations. This would allow an even more realistic simulation or animation of the workflow WF.

The planned movement paths Pk can of course be used to operate the linear motor 1, as explained above, for example. To this end, the control unit 10 controls the movement of the shuttles Tn according to the movement paths Pk and according to the workflow WF and with set dynamic parameters of the shuttles Tn.

In another advantageous aspect of the invention, the movement paths Pk are planned as explained above, but without the workflow view 13. Especially for simple linear motor application, this could be possible. This would lead to a configuration method for configuring a linear motor application, comprising the steps of arranging stator segments in a layout view of a planning view to form a workspace of the linear motor and displaying the workspace in the layout view, arranging workstations in the workspace, connecting the workstations in the layout view according to a given workflow that defines an order of sequence of workstations and automatically planning movement paths between the workstations in the workspace according to the order of sequence defined by the connections of the workstations and according to given movement planning rules. This would also lead to a configuration tool for configuring a linear motor application, comprising a configuration computer system with a display having a planning view, the computer system being configured to allow a user to arrange stator segments in the layout view to form a workspace of the linear motor and to display the workspace in the layout view, the computer system being further configured to allow a user to arrange workstations in the workspace, the computer system being further configured to allow a user to connect workstations in the layout view according to a given workflow that defines an order of sequence of workstations, and the configuration tool further comprises a movement path panning tool that is configured to automatically plan movement paths between the workstations in the workspace according to the order of sequence defined by the connections of the workstations and according to given planning rules.

## Claims

1. Configuration method for configuring a linear motor (1) application, comprising the steps of
- Arranging stator segments (Sm) in a layout view (12) of a planning view (11) to form a workspace (WS) of the linear motor (1) and displaying the workspace (WS) in the layout view (12),
- Arranging workstations (Wj) in the workspace (WS) and simultaneously displaying the workstations (Wj) in a workflow view (13) of the planning view (11), preferably next to the layout view (12),
- Connecting the workstations (WS) in the layout view (Wj) and/or in the workflow view (13) according to a given workflow (WF) that defines an order of sequence of workstations (Wj), whereas the workflow (WF) is displayed in the workflow view (13) in the form of a flowchart with the workstations (Wj) as nodes that are linked by connections that define the order of sequence,
- Dynamically linking the layout view (12) and the workflow view (13) such that a change in the configuration of the linear motor (1) in the layout view (12) is automatically reflected in the flowchart of the workflow view (13), and/or vice versa.

2. Configuration method according to claim 1, **characterized, in that** the step of arranging stator segments (Sm) in the layout view (12) is done graphically by drag and drop **in that** a stator segment (Sm) or a group of stator segments (Sm) is dragged into the layout view (12) and dropped at a desired position in the workspace (WS) where the stator segment (Sm) or the group of stator segments (Sm) is snaped-on a predefined grid of the workspace (WS) or an already present stator segment (Sm) or group of stator segments (Sm) in the workspace (WS).

3. Configuration method according to claim 1 or 2, **characterized, in that** the step of arranging workstations (Wj) in the layout view (12) is done graphically by drag and drop **in that** a workstation (Wj) is dragged into the layout view (12) and dropped at a desired position in the workspace (WS).

4. Configuration method according to any of claims 1 to 3, **characterized, in that** the step of connecting workstations (Wj) in the layout view (12) and/or in the workflow view (13) is done graphically by drawing a line between two workstations (Wj) in the layout view (12) or in the workflow view (13).

5. Configuration method according to any of claims 1 to 4, **characterized, in that** the step of dynamically linking comprises automatically adding a workstation (Wj) to the flowchart or removing a workstation (Wj) from the flowchart in the workflow view (13) when the workstation (Wj) is added to the layout view (12) or removed from the layout view (12), or vice versa.

6. Configuration method according to any of claims 1 to 5, **characterized, in that** the step of dynamically linking comprises automatically adding connections between workstations (Wj) in the layout view (12) when two workstations (Wj) are connected to each other in the flowchart in the workflow view (13).

7. Configuration method according to any of claims 1 to 6, **characterized, in that** the configuration method further comprises the step of automatically planning movement paths (Pk) between the workstations (Wj) in the workspace (WS) according to the order of sequence defined by the connections of the workstations (Wj) and according to given planning rules, the movement paths (Pk) defining routes of shuttles (Tn) of the linear motor (1).

8. Configuration method according to claim 7, **characterized, in that** the configuration method further comprises the step of automatically generating software instructions for moving the shuttles (Tn) along the movement paths (Pk) from workstation (Wj) to workstation (Wj) in the order of sequence of the flowchart for realizing the workflow (WF).

9. Configuration method according to claim 7 or 8, **characterized, in that** the configuration method further comprises the step of simulating the movement of the shuttles (Tn) along the movement paths (Pk) for realizing the workflow (WF) for a given time period and in accordance with given dynamic parameters of the movements of the shuttles (Tn).

10. Configuration method according to claim 9, **characterized, in that** the configuration method further comprises the step of animating the simulated movement of the shuttles (Tn) along the movement paths (Pk) for realizing the workflow (WF) in the layout view (12) for a given time period and in accordance with given dynamic parameters of the movements of the shuttles (Tn).

11. Configuration method according to claim 9 or 10, **characterized, in that** a characteristic parameter of the operation of the linear motor (1) is determined during the simulation.

12. Configuration tool for configuring a linear motor (1) application, comprising a configuration computer system (20) with a display (25) displaying a planning view (11), the configuration computer system (20) being configured to simultaneously display in the planning view (11) a layout view (12) and a workflow view (13), preferably next to the layout view (12), the configuration computer system being further configured to allow a user (22) to graphically arrange stator segments (Sm) in the layout view (12) to form a workspace (WS) of the linear motor (1) and to displaying the workspace (WS) in the layout view (12), the configuration computer (20) system being further configured to allow the user (22) to graphically arrange workstations (Wj) in the workspace (WS) and to simultaneously display the workstations (Wj) in the workflow view (13) of the planning view (11), the configuration computer system (20) being further configured to allow the user (22) to connect workstations (Wj) in the layout view (12) and/or in the workflow view (13) according to a given workflow (WF) that defines an order of sequence of workstations (Wj) and to display the workflow (WF) in the workflow view (13) in the form of a flowchart with the workstations (Wj) as nodes that are linked by connections that define the order of sequence, and the configuration computer system (20) being further configured to automatically dynamically link the layout view (12) and the workflow view (13) such that a change in the configuration of the linear motor (1) in the layout view (12) is automatically reflected in the flowchart of the workflow view (13), and/or vice versa.

13. Configuration tool according to claim 12, **characterized, in that** the configuration computer system (20) being configured to allow the user to graphically drag a stator segment (Sm) or a group of stator segments (Sm) into the layout view (12) and to drop the dragged stator segment (Sm) or a group of stator segments (Sm) at a desired position in the workspace (WS) where the stator segment (Sm) or the group of stator segments (Sm) is automatically snaped-on a predefined grid of the workspace (WS) or an already present stator segment (Sm) or group of stator segments (Sm) in the workspace (WS).

14. Configuration tool according to claim 12 or 13, **characterized, in that** the configuration computer system (20) being configured to allow the user to graphically drag a workstation (Wj) into the layout view (12) and to drop the dragged workstation (Wj) at a desired position in the workspace (WS).

15. Configuration tool according to any of claims 12 to 14, **characterized, in that** the configuration computer system (20) being configured to allow the user to graphically connect workstations (Wj) in the layout view (12) and/or in the workflow view (13) by drawing a line between two workstations (Wj) in the layout view (12) or in the workflow view (13).

16. Configuration tool according to any of claims 12 to 15, **characterized, in that** the configuration computer system (20) being configured to dynamically link the layout view (12) and the workflow view (13), **in that** a workstation (Wj) is automatically added to the layout view (12) or removed from the layout view (12) when the workstation (Wj) is added to the flowchart or the workstation (Wj) is removed from the flowchart in the workflow view (13), or vice versa.

17. Configuration tool according to any of claims 12 to 16, **characterized, in that** the configuration computer system (20) being configured to dynamically link the layout view (12) and the workflow view (13), **in that** a connection between workstations (Wj) is added in the layout view (12) when two workstations (Wj) are connected to each other in the flowchart in the workflow view (13).

18. Configuration tool according to any of claims 12 to 17, **characterized, in that** the configuration tool comprises a movement path planning tool that is configured to automatically plan movement paths (Pk) between the workstations (Wj) in the workspace (WS) according to the order of sequence defined by the connections of the workstations (Wj) and according to given planning rules, the movement paths (Pk) defining routes of shuttles (Tn) of the linear motor (1).

19. Configuration tool according to claim 18, **characterized, in that** the configuration tool comprises a software generation tool that is configured to automatically generate software instructions for moving the shuttles (Tn) along the movement paths (Pk) from workstation (Wj) to workstation (Wj) in the order of sequence of the flowchart for realizing the workflow (WF).

20. Configuration tool according to claim 18 or 19, **characterized, in that** the configuration tool comprises a simulation tool configured to simulate the movement of the shuttles (Tn) along the movement paths (Pk) for realizing the workflow (WF) for a given time period and in accordance with given dynamic parameters of the movements of the shuttles (Tn).

21. Configuration tool according to claim 20, **characterized, in that** the configuration tool comprises an animation tool configured to animate the simulated movement of the shuttles (Tn) along the movement paths (Pk) for realizing the workflow (WF) in the layout view (12) for a given time period and in accordance with given dynamic parameters of the movements of the shuttles (Tn).

22. Configuration tool according to claim 20 or 21, **characterized, in that** a characteristic parameter of the operation of the linear motor (1) is determined during the simulation by the simulation tool.
